# EUROPEAN PATENT APPLICATION

(11) **EP 4 174 536 A1**
(43) Date of publication of application: **03.05.2023**
(21) Application number: 21841193.2
(22) Date of filing: 18.05.2021
(51) Int. Cl.: G02B 5/08

(54) **MIRROR AND MANUFACTURING METHOD THEREFOR, LENS MODULE, AND ELECTRONIC DEVICE**

(30) Priority: 17.07.2020 CN 202010693017
(71) Applicant: Huawei Technologies Co., Ltd., Longgang District, Shenzhen, Guangdong 518129 (CN)
(72) Inventor: XU, Jinghui, Shenzhen, Guangdong 518129 (CN); SUN, Fengpei, Shenzhen, Guangdong 518129 (CN); FENG, Jun, Shenzhen, Guangdong 518129 (CN); LI, Ming, Shenzhen, Guangdong 518129 (CN)
(74) Representative: Gill Jennings & Every LLP
(86) International application number: PCT/CN2021/094379
(87) International publication number: WO 2022/012148

(57) **Abstract**

A reflector (10), a method for manufacturing the same, a lens module (001), and an electronic device are provided, and pertain to the field of optical technologies. The reflector (10) uses a silicon-based substrate (101) with a planar structure as abase material, which can effectively reduce a volume and mass of the reflector (10) when compared with a right triangular prism. In addition, an included angle (γ) between a second side surface (1d) and a second surface (1b) of the silicon-based substrate (101) is designed as an obtuse angle, to ensure that after the reflector (10) is arranged in an inclined manner, a right angle protruding outward is not formed between the second side face (1d) and the second surface (1b). Therefore, space occupied when the reflector (10) applied to a periscope camera module can be reduced, but also a risk of cracking or edge breakage of a side edge of the silicon-based substrate (101) caused due to collision or friction during assembly of the reflector (10) can be reduced.

## Description

This application claims priority to Chinese Patent Application No. 202010693017.5, filed on July 17, 2020 and entitled "REFLECTOR, METHOD FOR MANUFACTURING SAME, LENS MODULE AND ELECTRONIC DEVICE", which is incorporated herein by reference in its entirety.

### TECHNICAL FIELD

This application relates to the field of optical technologies, and specially, to a reflector, a method for manufacturing the same, a lens module, and an electronic device.

### BACKGROUND

To achieve telephoto imaging, an electronic device such as a mobile phone generally uses a periscope lens module. The periscope lens module may include a right triangular prism, a lens set, and a photosensitive element that are arranged in sequence. An included angle between an inclined plane of the right triangular prism and an optical axis of the lens set is 45 degrees, and the inclined plane can reflect incident light to the lens set. The lens set may then transmit the reflected light to the photosensitive element.

However, both a volume and mass of the right triangular prism are relatively large, resulting in a relatively large volume and relatively large mass of the lens module.

### SUMMARY

This application provides a reflector, a method for manufacturing the same, a lens module, and an electronic device, which can resolve a technical problem in related technologies that the use of a right triangular prism as a reflector leads to a relatively large volume and relatively large mass of the lens module.

According to one aspect, a reflector is provided. The reflector includes: a silicon-based substrate and first reflective film. The silicon-based substrate has a first surface and a second surface opposite to each other, a first side face, and a second side face. The first side face is connected to both the first surface and the second side face, and the second side face is connected to the second surface. The first reflective film is located on the first surface. An included angle between the first side face and the first surface is greater than a first angle threshold, and an included angle between the second side face and the first side face is greater than a second angle threshold. An included angle between the second side face and the second surface is an obtuse angle.

The reflector provided in this application uses a silicon-based substrate with a planar structure as a base material, which can effectively reduce a volume and mass of the reflector when compared with a right triangular prism. In addition, the included angle between the second side face and the second surface of the silicon-based substrate is designed as an obtuse angle, to ensure that after the reflector is arranged in an inclined manner, a right angle protruding outward is not formed between the second side face and the second surface. Therefore, space occupied when the reflector applied to a periscope camera module can be reduced, and further, a risk of cracking or edge breakage of a side edge of the silicon-based substrate caused due to collision or friction during assembly of the reflector can be effectively reduced.

Optionally, an included angle between the second side face and the first surface is 45 degrees. When the reflector is applied to a periscope camera module, the included angle between the first reflective film and an optical axis of the lens set is usually 45 degrees. Therefore, the included angle between the second side face and the first surface is also designed as 45 degrees, which can ensure that the second side face of the silicon-based substrate is parallel to the optical axis of the lens set, thereby ensuring that an angle protruding outward is not formed between the second side face and the second surface, and further reducing a risk of cracking or edge breakage of a side edge of the silicon-based substrate.

Optionally, the reflector further includes: second reflective film located on the second surface, and a material of the second reflective film may be the same as that of the first reflective film.

The first surface and the second surface of the silicon-based substrate are coated with reflective film of a same material, so that two types of stress generated by a thin-film coating process can be offset by each other, to further reduce deformation of the silicon-based substrate generated during thin-film coating, thereby ensuring quality of the prepared reflector.

Optionally, the material of the silicon-based substrate is monocrystalline silicon with a target crystallographic orientation. Because Young's moduli of monocrystalline silicon with different crystallographic orientations are different, using monocrystalline silicon with a same crystallographic orientation to form the silicon-based substrate can ensure consistency of an overall Young's modulus of the silicon-based substrate. Furthermore, relatively high consistency of stress resistance performance of the silicon-based substrate can be ensured, so that a reflector made by using the silicon-based substrate has better flatness.

Optionally, the target crystallographic orientation is (111). Because monocrystalline silicon with the crystallographic orientation of (111) has a higher Young's modulus, and has better stress resistance, the silicon-based substrate made of the monocrystalline silicon with the crystallographic orientation of (111) can further ensure flatness of the manufactured reflector.

Optionally, the first reflective film may be dielectric film or metal film. A material of the metal film may include at least one of aluminum, gold, and silver. A material of the dielectric film may be a non-metallic compound.

Optionally, a height of the first side face is equal to 0, and a height direction of the first side face is perpendicular to the first surface. The height of the first side face is designed as 0, to further reduce an overall thickness of the silicon-based substrate, thereby reducing a volume and quality of the reflector.

According to another aspect, a method for manufacturing a reflector is provided. In the method, a first reflective material film layer is formed first on a first face of a silicon wafer, and then the silicon wafer and the first reflective material film layer are processed, to obtain at least one reflector. Each reflector includes a silicon-based substrate obtained by processing the silicon wafer, and first reflective film obtained by processing the first reflective material film layer. The silicon-based substrate has a first surface and a second surface opposite to each other, a first side face, and a second side face. The first side face is connected to both the first surface and the second side face, and the second side face is connected to the second surface. The first reflective film is located on the first surface. An included angle between the first side face and the first surface is greater than a first angle threshold, and an included angle between the second side face and the first side face is greater than a second angle threshold. An included angle between the second side face and the second surface is an obtuse angle.

In the manufacturing method provided in this application, the silicon wafer and the first reflective material film layer may be processed to obtain a plurality of reflectors. In this way, mass production of reflectors may be achieved, thereby effectively improving reflector preparation efficiency, and reducing reflector preparation costs. In addition, performance consistency of a plurality of prepared reflectors can be ensured.

Optionally, a process of processing the silicon wafer and the first reflective material film layer may include: first, cutting the second face of the silicon wafer by using a first cutting blade to form a second side face of the reflector, where a cutting depth of the first cutting blade is less than a thickness of the silicon wafer, and the second face and the first face are two opposite faces of the silicon wafer; and then, continuing to cut the silicon wafer by using a second cutting blade, and cutting the first reflective material film layer, to form a first side face of the reflector and first reflective film of the reflector.

The foregoing mechanical cutting manner is relatively simple and efficient. In addition, first cutting blades of different shapes may be selected to form second side faces with different inclination angles, which helps to meet design requirements of different reflectors.

Optionally, the processing the silicon wafer and the first reflective material film layer may include: first, processing the first reflective material film layer and the silicon wafer, starting from a side, facing away from the silicon wafer, of the first reflective material film layer to form a first side face of the reflector and first reflective film of the reflector; and then, cutting the second face of the silicon wafer by using the first cutting blade to form a second side face of the reflector, where the second face and the first face are two opposite sides of the silicon wafer.

In this application, alternatively, the first reflective material film layer and the first face of the silicon wafer may be processed first, and then the second face of the silicon wafer is processed.

Optionally, a process of the processing the first reflective material film layer and the silicon wafer, starting from a side, facing away from the silicon wafer, of the first reflective material film layer may include: etching the first reflective material film layer and the silicon wafer, starting from the side, facing away from the silicon wafer, of the first reflective material film layer; or cutting the first reflective material film layer and the silicon wafer, starting from the side, facing away from the silicon wafer, of the first reflective material film layer by using a second cutting blade.

In the method provided in this application, the first reflective material film layer and the first face of the silicon wafer may be processed by using different processes, to form the first side face of the reflector and the first reflective film of the reflector. This manufacturing method has relatively high flexibility. Processing the first reflective material film layer through etching can prevent the first reflective material film layer from being cracked, and reliability of the etching is relatively high.

Optionally, before the processing the first reflective material film layer and the silicon wafer, starting from a side, facing away from the silicon wafer, of the first reflective material film layer, an alignment mark may be formed first on the second face of the silicon wafer, then the alignment mark may be used as a reference to process the first reflective material film layer and the silicon wafer, starting from a side, facing away from the silicon wafer, of the first reflective material film layer, and the alignment mark can be used as a reference to cut the second face of the silicon wafer by using the first cutting blade.

The alignment mark is formed first on the second face of the silicon wafer, so that subsequently, the alignment mark can be used as a reference to process the first face and the second face of the silicon wafer in sequence, so as to ensure that the silicon wafer can be effectively separated after the processing for two times, to obtain a plurality of reflectors.

Optionally, the method further includes: using a material the same as that of the first reflective material film layer to form a second reflective material film layer on the second face of the silicon wafer; and processing the second reflective material film layer to obtain second reflective film in the reflector, where the second reflective film is located on the second surface of the silicon-based substrate.

Reflective material film layers made of a same material are formed on the first face and the second face of the silicon wafer, so that two types of stress generated by a thin-film coating process can be offset by each other, to further reduce deformation of the silicon wafer generated during thin-film coating, thereby ensuring flatness of the prepared reflector.

Still another aspect provides a lens module. The lens module includes the reflector provided in the foregoing aspect, a lens set, and a photosensitive element. The lens set is located between the reflector and the photosensitive element, first reflective film in the reflector is closer to the lens set than a silicon-based substrate, and the first reflective film is configured to reflect incident light to the lens set.

Optionally, an included angle between a second side face and the first surface of the silicon-based substrate is equal to an included angle between the first reflective film and an optical axis of the lens set. In this way, it may be ensured that the second side face of the silicon-based substrate is parallel to the optical axis of the lens set, thereby ensuring that an angle protruding outward is not formed between the second side face and the second surface, and further reducing a risk of cracking or edge breakage of a side edge of the silicon-based substrate.

Optionally, the included angle between the first reflective film and the optical axis of the lens set is 45 degrees.

Yet another aspect provides an electronic device. The electronic device includes: a housing, and the lens module that is provided in the foregoing aspect and that is arranged in the housing.

In summary, embodiments of this application provide a reflector, a method for manufacturing the same, a lens module, and an electronic device. The reflector uses a silicon-based substrate with a planar structure as a base material, which can effectively reduce a volume and mass of the reflector when compared with a right triangular prism. In addition, an included angle between a second side face and a second surface of the silicon-based substrate is designed as an obtuse angle, to ensure that after a reflector is arranged in an inclined manner, a right angle protruding outward is not formed between the second side face and the second surface. Therefore, space occupied when the reflector applied to a periscope camera module can be reduced, and further, a risk of cracking or edge breakage of a side edge of the silicon-based substrate caused due to collision or friction during assembly of the reflector can be effectively reduced. Moreover, because a Young's modulus of the silicon-based substrate is relatively high, coating of the surface of the silicon-based substrate with reflective film does not cause relatively large deformation of the silicon-based substrate, which can ensure relatively high quality of the prepared reflector.

### BRIEF DESCRIPTION OF DRAWINGS

FIG. 1 is a schematic diagram of a structure of a reflector according to an embodiment of this application;
FIG. 2 is a schematic diagram of a partial structure of a periscope camera module according to an embodiment of this application;
FIG. 3 is a schematic diagram of a partial structure of another periscope camera module;
FIG. 4 is a schematic diagram of an amount of deformation when optical glass is used as a base;
FIG. 5 is a schematic diagram of a structure of silicon-based substrate according to an embodiment of this application;
FIG. 6 is a schematic diagram of an amount of deformation when a silicon-based substrate with a crystallographic orientation of (100) is used as a base according to an embodiment of this application;
FIG. 7 is a schematic diagram of an amount of deformation when a silicon-based substrate with a crystallographic orientation of (111) is used as a base according to an embodiment of this application;
FIG. 8 is a schematic diagram of a structure of another reflector according to an embodiment of this application;
FIG. 9 is a schematic diagram of an amount of deformation when a silicon-based substrate with a crystallographic orientation of (111) is used as a base and two surfaces of the silicon-based substrate are both coated with reflective film;
FIG. 10 is a schematic diagram of a structure of still another reflector according to an embodiment of this application;
FIG. 11 is a schematic diagram of a structure of yet another reflector according to an embodiment of this application;
FIG. 12 is a flowchart of a method for manufacturing a reflector according to an embodiment of this application;
FIG. 13 is a flowchart of another method for manufacturing a reflector according to an embodiment of this application;
FIG. 14 is a schematic diagram of a manufacturing process of a reflector according to an embodiment of this application;
FIG. 15 is a schematic diagram of a first cutting blade according to an embodiment of this application;
FIG. 16 is a cross-sectional view of a second cutting blade according to an embodiment of this application;
FIG. 17 is a flowchart of still another method for manufacturing a reflector according to an embodiment of this application;
FIG. 18 is a schematic diagram of another manufacturing process of a reflector according to an embodiment of this application;
FIG. 19 is a flowchart of yet another method for manufacturing a reflector according to an embodiment of this application;
FIG. 20 is a schematic diagram of a structure of a periscope camera module according to an embodiment of this application; and
FIG. 21 is a schematic diagram of a structure of an electronic device according to an embodiment of this application.

### DESCRIPTION OF EMBODIMENTS

The following describes in detail a reflector, a method for manufacturing the same, a lens module, and an electronic device provided in embodiments of this application with reference to the accompanying drawings.

An embodiment of this application provides a reflector. The reflector is made of a silicon-based substrate with a planar structure, to resolve a problem of a large volume and mass of a triangular prism in related technologies.

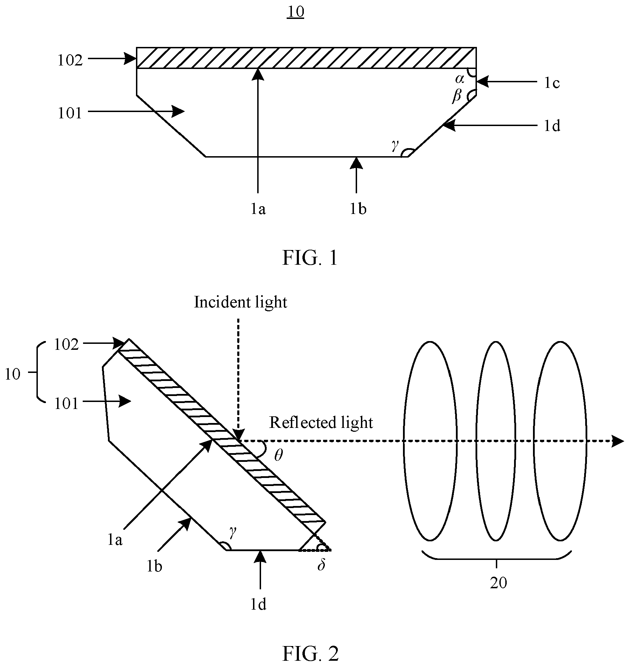

FIG. 1 is a schematic diagram of a structure of a reflector according to an embodiment of this application. As shown in FIG. 1, the reflector 10 includes a silicon-based substrate 101 and first reflective film 102.

The silicon-based substrate 101 has a first surface 1a and a second surface 1b opposite to each other, a first side face 1c, and a second side face 1d. The first side face 1c is connected to both the first surface 1a and the second side face 1d, and the second side face 1d is connected to the second surface 1b. That the first surface 1a and the second surface 1b are opposite to each other means that the first surface 1a is parallel to the second surface 1b, or the first surface 1a is approximately parallel to the second surface 1b.

The first reflective film 102 is located on the first surface 1a, and an included angle α between the first side face 1c and the first surface 1a is greater than a first angle threshold. An included angle β between the second side face 1d and the first side face 1c is greater than a second angle threshold. An included angle γ between the second side face 1d and the second surface 1b is an obtuse angle. That is, the silicon-based substrate 101 has a second side face inclined with respect to a surface of the silicon-based substrate 101.

The first angle threshold may be an acute angle approximate to 90°, and the second angle threshold may be an acute angle or an obtuse angle approximate to 90°. In addition, the first angle threshold may be equal to or not equal to the second angle threshold. For example, the first angle threshold may be 80° or 85°, and the second angle threshold may be 90°. In other words, both the included angle α between the first side face 1c and the first surface 1a and the included angle β between the second side face 1d and the first side face 1c are relatively large angles. For example, the included angle α may be a right angle or an acute angle close to a right angle, and the included angle β may be a right angle or an obtuse angle. Both the included angle α between the first side face 1c and the first surface 1a and the included angle β between the second side face 1d and the first side face 1c are designed as relatively large angles, to effectively reduce a risk of cracking or edge breakage caused due to collision or friction during packaging of the reflector, thereby ensuring a yield rate of the reflector.

The reflector 10 provided in this embodiment of this application may be applied to a periscope camera module. FIG. 2 is a schematic diagram of a partial structure of a periscope camera module according to an embodiment of this application. As shown in FIG. 2, in the periscope camera module, the reflector 10 needs to be arranged in an inclined manner, so that an included angle between the first reflective film 102 in the reflector 10 and an optical axis (parallel to a transmission direction of emitted light in FIG. 2) of a lens set 20 in the periscope camera module is an acute angle. For example, the included angle is 45°. Because an included angle γ between the second side face 1d and the second surface 1b of the silicon-based substrate 101 in the reflector 10 is an obtuse angle, when the reflector 10 is arranged in an inclined manner, the second side face 1d may be parallel to or approximately parallel to the optical axis of the lens set 20.

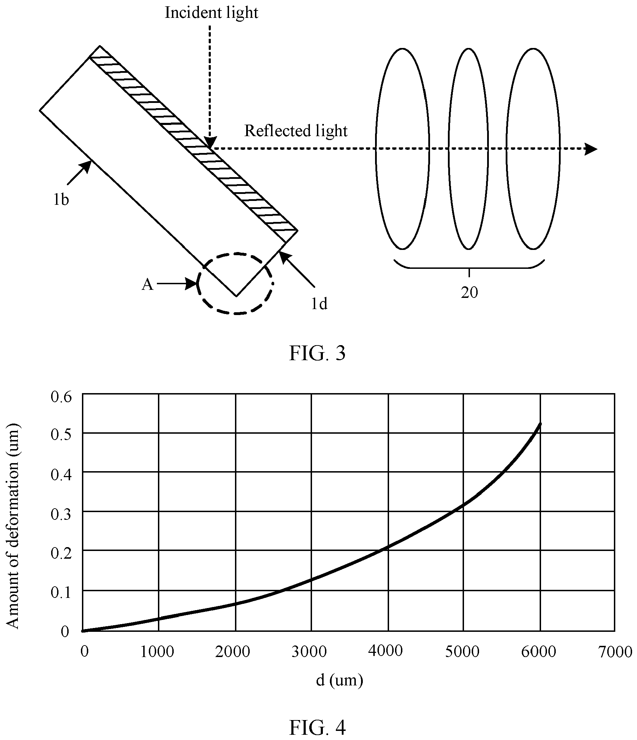

If the second side face 1d of the silicon-based substrate 101 is designed to be perpendicular to the second surface 1b, as shown in the part A in FIG. 3, after the reflector 10 is arranged in an inclined manner, a right angle formed between the second side face 1d and the second surface 1b of the silicon-based substrate 101 occupies relatively large space. Moreover, cracking or edge breakage of the right angle easily occurs due to collision or friction during assembly of the reflector 10.

Based on the analysis above, it may be learned that, in the reflector 10 provided in this embodiment of this application, the included angle γ between the second side face 1d and the second surface 1b of the silicon-based substrate 101 is designed as an obtuse angle, to ensure that after the reflector 10 is arranged in an inclined manner, a right angle protruding outward is not formed between the second side face 1d and the second surface 1b. Therefore, space occupied by the reflector 10 can be reduced, and further, a risk of cracking or edge breakage of a side edge of the silicon-based substrate 101 caused due to collision or friction during assembly of the reflector 10 can be effectively reduced.

Optionally, in this embodiment of this application, when the reflector 10 is applied to the periscope camera module, as shown in FIG. 2, after the reflector 10 is arranged in an inclined manner, the included angle between the first reflective film 102 and the optical axis of the lens set 20 is *θ*. In order to enable the second side face 1d of the silicon-based substrate 101 to be parallel to the optical axis of the lens set 20, an included angle δ between the second side face 1d and the first surface 1a of the silicon-based substrate 101 may be designed as an angle equal to the included angle *θ*. Alternatively, it may be understood that the included angle γ between the second side face 1d and the second surface 1b of the silicon-based substrate 101 is designed as an angle supplementary to the included angle *θ*.

For example, assuming that the included angle *θ* between the first reflective film 102 and the optical axis of the lens set 20 is 45°, the included angle δ between the second side face 1d and the first surface 1a of the silicon-based substrate 101 may be 45°, and the included angle γ between the second side face 1d and the second surface 1b of the silicon-based substrate 101 may be 135°.

The included angle δ between the second side face 1d and the first surface 1a of the silicon-based substrate 101 is designed as an angle equal to the included angle *θ*, so that when the reflector 10 is applied to the periscope camera module, the second side face 1d of the silicon-based substrate 101 may be parallel to the optical axis of the lens set 20. Therefore, it may be ensured that an angle protruding outward is not formed between the second side face 1d and the second surface 1b, thereby further reducing a risk of cracking or edge breakage of a side edge of the silicon-based substrate 101.

In related technologies, a solution of coating optical glass with reflective film to prepare a reflector is usually used. However, because a Young's modulus of optical glass is relatively small, which is generally 70 gigapascals (GPa), before the optical glass is coated, it is necessary to first grind and polish a concave surface on the optical glass to offset deformation of the optical glass caused by stress generated during coating of the reflective film.

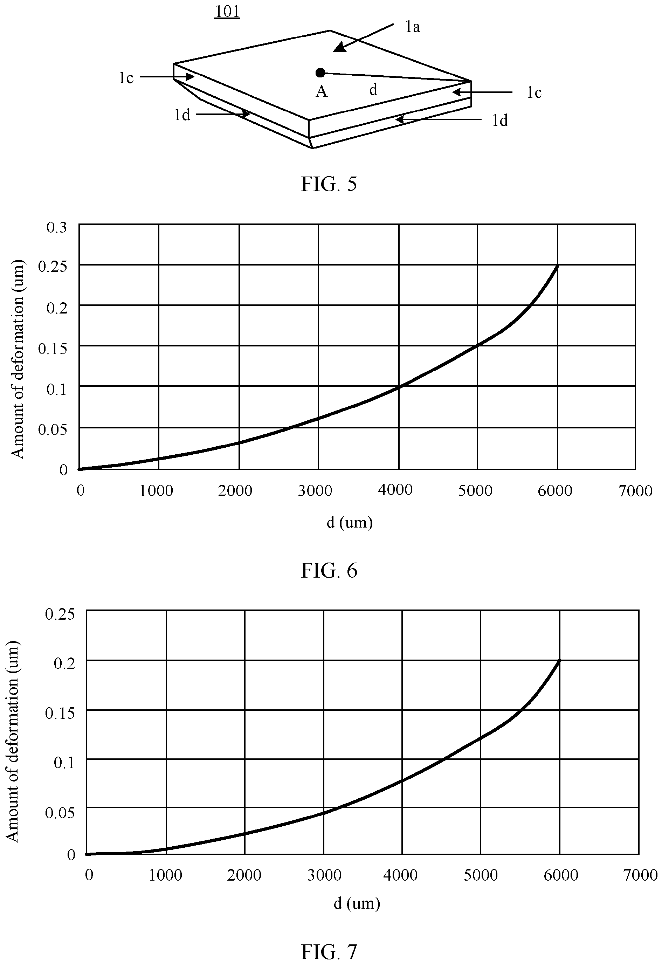

In this embodiment of this application, a material of the silicon-based substrate 101 may be monocrystalline silicon. A Young's modulus of the monocrystalline silicon is about 169 GPa, which is much higher than that of the optical glass. Therefore, in the case of same stress caused by thin film coating, an amount of deformation of the silicon-based substrate 101 is smaller. For example, FIG. 4 is a schematic diagram of an amount of deformation when optical glass is used as a base. Refer to the reference signs in FIG. 5. A horizontal axis in FIG. 4 represents a distance d from a center point A of the base, which is measured in units of microns (µm), and a vertical axis represents an amount of deformation of the base (also referred to as warpage displacement), which is measured in units of µm. It may be seen from FIG. 4 that when optical glass is used as a base of a reflector, stress generated during preparation of reflective film causes deformation of 0.52 µm at a corner of the optical glass. FIG. 6 is a schematic diagram of an amount of deformation when a silicon-based substrate with a crystallographic orientation of (100) is used as a base. As shown in FIG. 6, when a silicon-based substrate with a crystallographic orientation of (100) is used as a base of a reflector, stress with a same value generated during preparation of reflective film causes deformation of 0.24 µm at a corner of the silicon-based substrate. An amount of deformation decreases by 2.2 times when compared with that of optical glass.

A Young's modulus of the silicon-based substrate is relatively high, and stress generated during preparation of the reflective film causes a relatively small amount of deformation of the silicon-based substrate. Therefore, it is no longer necessary to use the method of grinding and polishing a concave surface in advance to offset deformation caused by the stress. Therefore, this can effectively reduce complexity of a reflector manufacturing process, decrease manufacturing costs, and improve a yield rate of the process.

Optionally, the material of the silicon-based substrate 101 may be monocrystalline silicon with a target crystallographic orientation. That is, crystallographic orientations of monocrystalline silicon used by the silicon-based substrate 101 are consistent. Because Young's moduli of monocrystalline silicon with different crystallographic orientations are different, using monocrystalline silicon with a same crystallographic orientation to form the silicon-based substrate 101 can ensure consistency of an overall Young's modulus of the silicon-based substrate 101. Furthermore, relatively high consistency of stress resistance performance of the silicon-based substrate 101 can be ensured, so that a reflector 10 made by using the silicon-based substrate 101 has better flatness.

In this embodiment of this application, the crystallographic orientation of the monocrystalline silicon used by the silicon-based substrate 101 may be (111). The monocrystalline silicon with the crystallographic orientation of (111) may be represented as monocrystalline silicon (111). A Young's modulus of the monocrystalline silicon (111) is 188 GPa, which is greater than a Young's modulus of monocrystalline silicon (100), which is 169 GPa. Therefore, the monocrystalline silicon (111) has better stress resistance than the monocrystalline silicon (100). For example, FIG. 7 is a schematic diagram of an amount of deformation when a silicon-based substrate with a crystallographic orientation of (111) is used as a base. It may be seen, through comparison between FIG. 6 and FIG. 7, that when same coating stress is generated, deformation of the silicon-based substrate 101 using the monocrystalline silicon (100) is 0.24 µm while deformation of the silicon-based substrate 101 using the monocrystalline silicon (111) is only 0.2 µm. The amount of deformation decreases by 18%.

It may be learned from this that use of the silicon-based substrate 101 made by using the monocrystalline silicon (111) can further ensure flatness of the manufactured reflector 10.

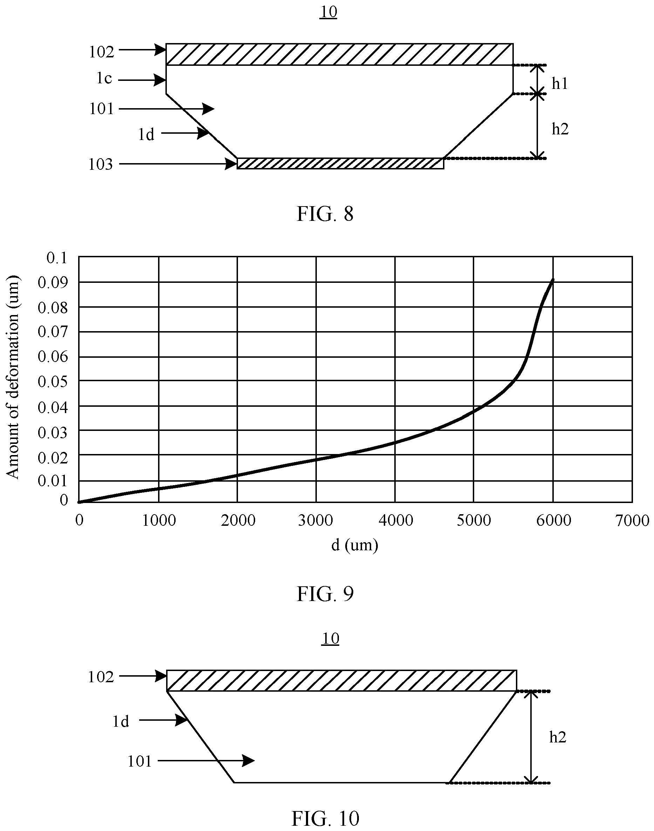

Optionally, as shown in FIG. 8, the reflector 10 provided in this embodiment of this application further includes: second reflective film 103 located on the second surface 1b, and a material of the second reflective film 103 may be the same as that of the first reflective film 102.

The first surface 1a and the second surface 1b of the silicon-based substrate 101 are coated with reflective film of a same material, so that two types of stress generated by a thin-film coating process can be offset by each other, to further reduce deformation of the silicon-based substrate 101 generated during thin-film coating. For example, FIG. 9 is a schematic diagram of an amount of deformation when a silicon-based substrate with a crystallographic orientation of (111) is used as a base and two surfaces of the silicon-based substrate are both coated with reflective film. It may be seen, through comparison between FIG. 7 and FIG. 9, that deformation of the silicon-based substrate 101 is about 0.2 µm when only the first surface 1a of the silicon-based substrate 101 is coated. When both the first surface 1a and the second surface 1b of the silicon-based substrate 101 are coated, deformation of the silicon-based substrate 101 may be reduced to 0.09 µm. An amount of deformation is reduced by 2.2 times, which significantly improves a deformation resistance effect of the silicon-based substrate 101.

Optionally, in this embodiment of this application, the first reflective film 102 in the reflector 10 may be dielectric film or metal film. A material of the metal film may include at least one of aluminum, gold and silver. A material of the dielectric film may be a non-metallic compound.

Certainly, in addition to the dielectric film and the metal film, the first reflective film 102 may alternatively be made of other materials, provided that the first reflective film can effectively reflect light.

In this embodiment of this application, as shown in FIG. 8, a height h1 of the first side face 1c of the silicon-based substrate 101 may be less than a height h2 of the second side face 1d. Height directions of the first side face 1c and the second side face 1d are both perpendicular to the first surface of the silicon-based substrate 101.

Optionally, as shown in FIG. 10, the height h1 of the first side face 1c of the silicon-based substrate 101 may be 0. That is, the silicon-based substrate 101 may not include the first side face 1c, but include only the second side face 1d. In this way, a thickness of the silicon-based substrate 101 can be effectively reduced, thereby reducing a volume and quality of the reflector 10.

Optionally, as shown in FIG. 5, the first surface 1a of the silicon-based substrate 101 may be a rectangle, for example, may be a square. Accordingly, the silicon-based substrate 101 may not include four first side faces 1c and four second side faces 1d. Included angles of the first side faces 1c and the first surfaces 1a may be equal or not equal to each other. Included angles between the second side faces 1d and the second surfaces 1b (not shown in FIG. 5) may be equal or not equal to each other.

In this embodiment of this application, in order to ensure symmetry of an overall structure of the reflector 10, the included angles of the first side faces 1c and the first surfaces 1a of the silicon-based substrate 101 may be equal to each other, for example, all of them are 90°. In addition, the included angles between the second side faces 1d and the second surfaces 1b may also be equal to each other, for example, all of them are 135°.

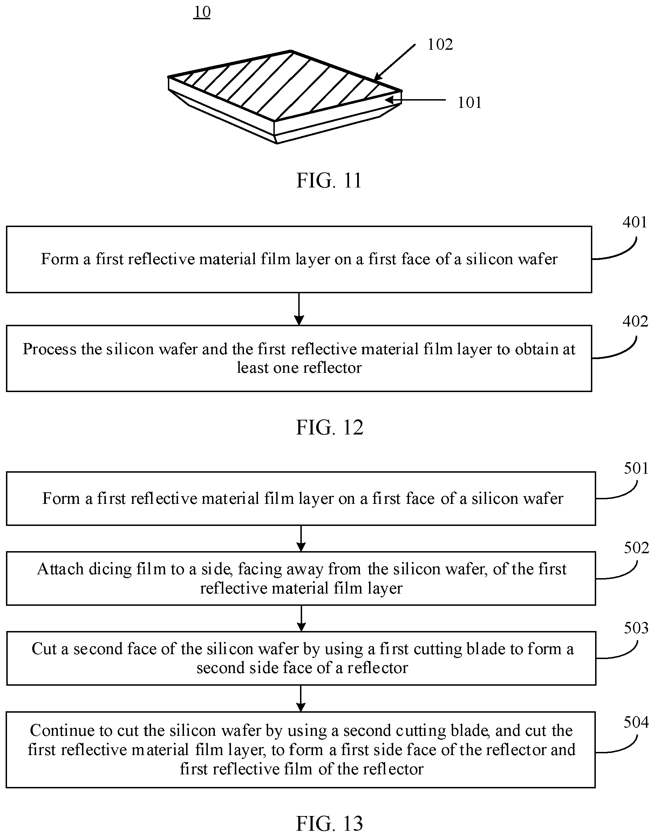

FIG. 11 is a schematic diagram of a structure of yet another reflector according to an embodiment of this application. As shown in FIG. 11, the first reflective film 102 may cover the first surface 1a. To be specific, a shape of the first reflective film 102 is the same as that of the first surface 1a, and a size of the first reflective film 102 is also the same as that of the first surface 1a.

In addition, embodiments of this application provide a reflector. The reflector uses a silicon-based substrate with a planar structure as a base material, which can effectively reduce a volume and mass of the reflector when compared with a right triangular prism. In addition, the included angle between the second side face and the second surface of the silicon-based substrate is designed as an obtuse angle, to ensure that after the reflector is arranged in an inclined manner, a right angle protruding outward is not formed between the second side face and the second surface. Therefore, space occupied when the reflector applied to a periscope camera module can be reduced, and further, a risk of cracking or edge breakage of a side edge of the silicon-based substrate caused due to collision or friction during assembly of the reflector can be effectively reduced. Moreover, because a Young's modulus of the silicon-based substrate is relatively high, coating of the surface of the silicon-based substrate with reflective film does not cause relatively large deformation of the silicon-based substrate, which can ensure flatness of the prepared reflector.

An embodiment of this application further provides a method for manufacturing a reflector. The method may be used to manufacture the reflector provided in the foregoing embodiments. Refer to FIG. 12. The method may include the following steps.

Step 401: Form a first reflective material film layer on a first face of a silicon wafer.

In this embodiment of this application, a silicon wafer made of monocrystalline silicon may be used as a material for forming a silicon-based substrate. The silicon wafer may be made of monocrystalline silicon, for example, may be made of monocrystalline silicon (111). In addition, resistivity of the monocrystalline silicon is not limited in this embodiment of this application.

Optionally, the first reflective material film layer may be dielectric film. Accordingly, the first reflective material film layer may be formed by using a chemical vapor deposition (chemical vapor deposition, CVD) or plasma enhanced chemical vapor deposition (plasma enhanced chemical vapor deposition, PECVD) process.

Alternatively, the first reflective material film layer may be metal film. Accordingly, the first reflective material film layer may be formed by a magnetron sputtering process or an e-beam evaporation (e-beam evaporation) process.

Because the silicon wafer has a relatively high Young's modulus, relatively high stress resistance, and relatively small amount of deformation generated after coating, a surface of the silicon wafer may be directly coated without grinding and polishing a concave surface on the surface of the silicon wafer in advance to offset stress generated by a coating process. Therefore, this effectively reduces complexity of a reflector manufacturing process, decreases reflector manufacturing costs, and improves reflector preparation efficiency.

Step 402: Process the silicon wafer and the first reflective material film layer to obtain at least one reflector.

In this embodiment of this application, the silicon wafer and the first reflective material film layer may be cut to obtain at least one reflector. Alternatively, the silicon wafer and the first reflective material film layer may be etched and cut to obtain at least one reflector.

As shown in FIG. 1, each prepared reflector includes a silicon-based substrate 101 obtained by processing the silicon wafer, and first reflective film 102 obtained by processing the first reflective material film layer. The silicon-based substrate 101 has a first surface 1a and a second surface 1b opposite to each other, a first side face 1c, and a second side face 1d. The first side face 1c is connected to both the first surface 1a and the second side face 1d, and the second side face 1d is connected to the second surface 1b. The first reflective film 102 is located on the first surface 1a, and an included angle α between the first side face 1c and the first surface 1a is greater than a first angle threshold. An included angle β between the second side face 1d and the first side face 1c is greater than a second angle threshold. An included angle γ between the second side face 1d and the second surface 1b is an obtuse angle.

In the manufacturing method provided in this embodiment of this application, the silicon wafer and the first reflective material film layer may be processed to obtain a plurality of reflectors. In this way, mass production of reflectors may be achieved, thereby effectively improving reflector preparation efficiency, and reducing reflector preparation costs. In addition, performance consistency of a plurality of prepared reflectors can be ensured.

In an optional implementation, as shown in FIG. 13, a method for manufacturing a reflector provided in an embodiment of this application may include the following steps.

Step 501: Form a first reflective material film layer on a first face of a silicon wafer.

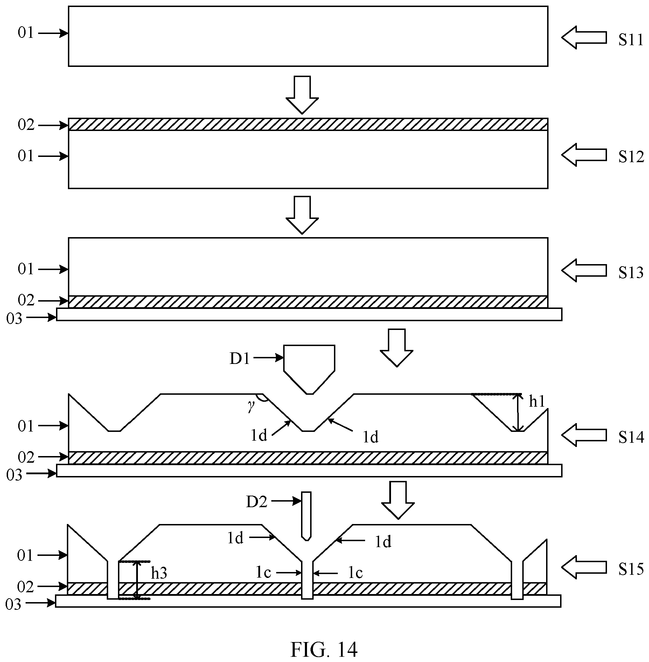

Refer to steps S11 and S12 in FIG. 14. A silicon wafer 01 may be obtained first, and then a first reflective material film layer 02 is formed on a first face of the silicon wafer 01. For an implementation process of step 501, refer to the foregoing step 401. Details are not described herein again.

Step 502: Attach dicing film to a side, facing away from the silicon wafer, of the first reflective material film layer.

Refer to step S13 in FIG. 14. The silicon wafer 01 provided with the first reflective material film layer 02 may be turned over, and then the side, facing away from the silicon wafer 01, of the first reflective material film layer 02 is attached to the dicing film 03. Optionally, the dicing film may be ultraviolet (ultraviolet, UV) film with viscosity.

Step 503: Cut a second face of the silicon wafer by using a first cutting blade to form a second side face of the reflector.

Refer to step S14 in FIG. 14. The first cutting blade (also referred to as a V-shaped blade or a V-shaped hub cutting blade) D1 may be used to cut the second face of the silicon wafer 01. The second face and the first face are two opposite faces of the silicon wafer 01, for example, the second face is parallel to the first face. A cutting depth h1 of the first cutting blade D1 is less than a thickness of the silicon wafer 01.

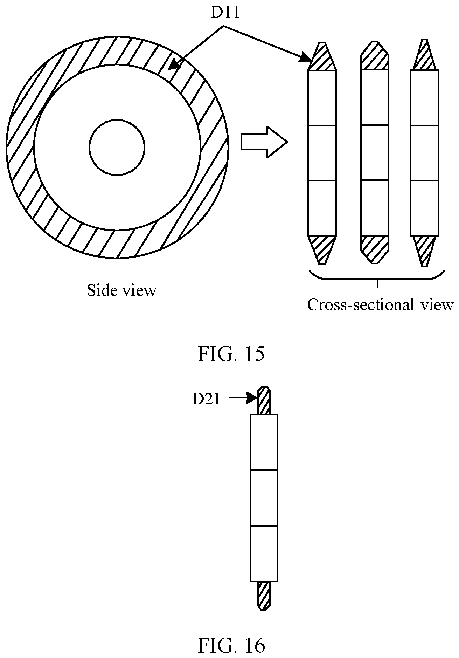

FIG. 15 is a schematic diagram of a first cutting blade according to an embodiment of this application. Refer to the side view in FIG. 15. The first cutting blade D1 may be of a ring shape. FIG. 15 further shows three optional cross-sectional views of the first cutting blade. As shown in the cross-sectional views on the left side and the right side in FIG. 15, a cross section of a cutting edge D11 of the first cutting blade D1 may be trapezoidal. Alternatively, as shown the cross-sectional view in the middle in FIG. 15, the cross section of the cutting edge D11 may be a hexagon including a rectangle and a trapezoid. In addition, as shown in the cross-sectional views respectively on the left side and in the middle in FIG. 15, a maximum thickness of the cutting edge D11 may be equal to a thickness of a central part of the first cutting blade D1. Alternatively, as shown in the cross-sectional view on the right side in FIG. 15, the maximum thickness of the cutting edge D11 may be less than the thickness of the central part of the first cutting blade D1.

After the second face of the silicon wafer 01 is cut by using the first cutting blade D1, a bevel groove may be formed on the second face of the silicon wafer 01, and a side wall of the bevel groove may become the second side face 1d of the silicon-based substrate in the reflector. During manufacturing, first cutting blades D1 of different shapes may be flexibly selected for cutting the silicon wafer 01 based on different inclination angles (which are included angles between the second side face 1d and the second surface) of the second side face 1d that are required by design Cutting the silicon wafer 01 by using the first cutting blade D1 can achieve precise control and adjustment of the inclination angle of the second side face 1d formed through cutting, which helps to meet design requirements of different reflectors.

Step 504: Continue to cut the silicon wafer by using a second cutting blade, and cut the first reflective material film layer, to form a first side face of the reflector and a first reflective film of the reflector.

Refer to step S15 in FIG. 14. The second cutting blade (which may also be referred to as a straight cutting blade or a vertical hub cutting blade) D2 may be used to continue to cut the silicon wafer 01, starting from a bottom surface of the bevel groove of the silicon wafer 01, and cut the first reflective material film layer 02. In this way, the first side face of the reflector and the first reflective film of the reflector can be formed. A cutting direction of the second cutting blade D2 may be perpendicular to the first face of the silicon wafer 01, and correspondingly, the first side face formed through cutting is perpendicular to the first surface of the silicon-based substrate.

For a side view of the second cutting blade D2, refer to the side view shown in FIG. 15. That is, the second cutting blade D2 may also be of a ring shape. FIG. 16 is a cross-sectional view of a second cutting blade according to an embodiment of this application. As shown in FIG. 16, a cross section of a cutting edge D21 of the second cutting blade D2 may be a hexagon including a rectangle and a trapezoid. A maximum thickness of the cutting edge D21 is less than a thickness of a central part of the second cutting blade D2.

In this embodiment of this application, a cutting depth h3 when the second cutting blade D2 is used for cutting may be greater than or equal to a sum of a remaining thickness of the silicon wafer 01 obtained after being cut by using the first cutting blade D1 and a thickness of the first reflective material film layer 02. That is, the second cutting blade D2 may thoroughly cut the silicon wafer 01 provided with the first reflective material film layer 02 to obtain a plurality of separated reflectors.

As shown in FIG. 14, because the dicing film 03 is attached to the side, facing away from the silicon wafer 01, of the first reflective material film layer 02, after the plurality of reflectors are separated by using the second cutting blade D2, the plurality of reflector may be fixed on the dicing film 03, to prevent the reflectors from being scattered (also referred to as flying pieces) and causing damage.

In this embodiment of this application, if mass production of a plurality of reflectors is required, the foregoing step 503 may be performed a plurality of times, that is, the second face of the silicon wafer may be cut a plurality of times by using the first cutting blade, to obtain a plurality of bevel grooves. Correspondingly, the foregoing step 504 may also be performed a plurality of times, that is, the silicon wafer and the first reflective material film layer may be cut a plurality of times by using the second cutting blade, to obtain a plurality of separated reflectors. Then, the plurality of separated reflectors may be peeled off from the dicing film and respectively packaged in periscope camera modules. If the dicing film is UV film, a UV irradiation device may be used to irradiate the UV film to reduce viscosity of the UV film, so as to peel off the reflector.

The foregoing method for mechanically cutting a silicon wafer and a reflective material film layer by using two different types of cutting blades is relatively simple and has relatively high efficiency.

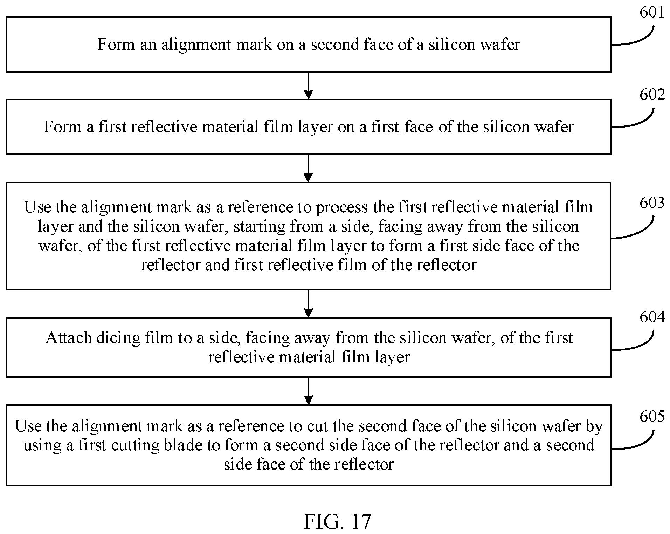

In another optional implementation, as shown in FIG. 17, a method for manufacturing a reflector provided in an embodiment of this application may include the following steps.

Step 601: Form an alignment mark on a second face of a silicon wafer.

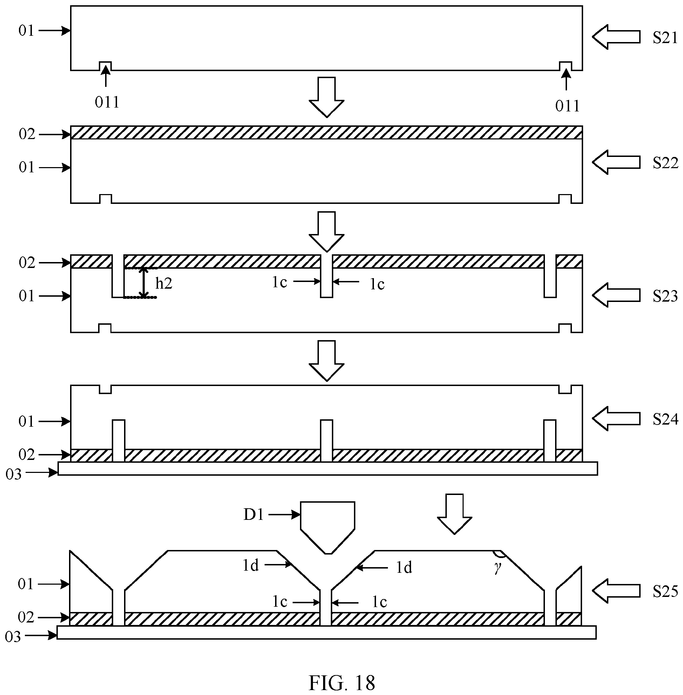

In this embodiment of this application, as shown in step S21 in FIG. 18, a plurality of alignment marks 011 may be formed on the second face of the silicon wafer 01. The plurality of alignment marks 011 may be located at edges of the silicon wafer 01.

Optionally, a plurality of grooves may be formed, through etching or cutting, on the second face of the silicon wafer 01 as the alignment marks 011. For example, the alignment mark 011 may be formed on the second face of the silicon wafer 01 by using a deep reactive ion etching (deep reactive ion etching, DRIE) technology. Alternatively, an alignment mark may be directly attached to or coated on the second face of the silicon wafer 01.

Step 602: Form a first reflective material film layer on a first face of a silicon wafer.

Refer to step S22 in FIG. 18. The first reflective material film layer 02 may be formed on the first face (namely, a face on which no alignment mark 011 is formed) of the silicon wafer 01. The first face and the second face are two opposite faces of the silicon wafer 01. For an implementation process of step 602, refer to the foregoing step 401. Details are not described herein again.

Step 603: Use the alignment mark as a reference to process the first reflective material film layer and the silicon wafer, starting from a side, facing away from the silicon wafer, of the first reflective material film layer to form a first side face of the reflector and first reflective film of the reflector.

In this embodiment of this application, as shown in step S23 in FIG. 18, the alignment mark may be used as a reference to process the first reflective material film layer and the silicon wafer, to form a rectangle-groove in the first reflective material film layer and the silicon wafer. A side wall of the rectangle-groove may be formed as the first side face of the reflector. In addition, because the rectangle-groove penetrates through the first reflective material film layer 02, the first reflective film of the reflector may be further formed.

In an optional implementation, the first reflective material film layer 02 and the silicon wafer 01 may be etched, starting from a side, facing away from the silicon wafer 01, of the first reflective material film layer 02 to form a first side face 1c of the reflector and first reflective film of the reflector. For example, the first reflective material film layer 02 and the silicon wafer 01 may be etched by using the DRIE technology. An etching depth of the first reflective material film layer 02 may be equal to a thickness of the first reflective material film layer 02, that is, the first reflective material film layer 02 needs to be thoroughly etched. An etching depth h2 of the silicon wafer 01 may be less than a thickness of the silicon wafer 01.

Because the thickness of the first reflective material film layer 02 is relatively thin, processing the first reflective material film layer 02 through etching can effectively reduce a probability of occurrence of cracks in the first reflective material film layer 02. In other words, reliability of the etching is higher, and a yield rate of the prepared reflector can be ensured.

In another optional implementation, the first reflective material film layer 02 and the silicon wafer 01 may be cut, starting from a side, facing away from the silicon wafer 01, of the first reflective material film layer 02 by using a second cutting blade to form a first side face 1c of the reflector and first reflective film of the reflector. A depth of the first reflective material film layer 02 cut by using the second cutting blade may be equal to a thickness of the first reflective material film layer 02, that is, the first reflective material film layer 02 needs to be thoroughly etched. A cutting depth h2 of the silicon wafer 01 may be less than a thickness of the silicon wafer 01. In addition, a cutting direction of the second cutting blade may be perpendicular to the first face of the silicon wafer 01.

Step 604: Attach dicing film to a side, facing away from the silicon wafer, of the first reflective material film layer.

Refer to step S24 in FIG. 18. The first reflective material film layer 02 and the silicon wafer 01 may be turned over, and then the side, facing away from the silicon wafer 01, of the first reflective material film layer 02 is attached to the dicing film 03. For an implementation process of step 604, refer to the foregoing step 502. Details are not described herein again.

Step 605: Use the alignment mark as a reference to cut the second face of the silicon wafer by using a first cutting blade to form a second side face of the reflector and a second side face of the reflector.

Refer to step S25 in FIG. 18. The first cutting blade D1 may be used to cut the second face of the silicon wafer 01 to form a bevel groove on the second face of the silicon wafer 01. To ensure that the bevel groove is connected to rectangle-groove formed in the foregoing step 603, that is, to ensure that the silicon wafer 01 is thoroughly cut, the alignment mark needs to be used as a reference for cutting. After the second face of the silicon wafer 01 is cut by using the first cutting blade D1, the second side face of the reflector may be formed.

In this embodiment of this application, if mass production of a plurality of reflectors is required, in the foregoing step 603, a plurality of rectangle-grooves may be formed in the first reflective material film layer and the silicon wafer. Correspondingly, the foregoing step 605 may be performed a plurality of times, that is, the silicon wafer may be cut a plurality of times by using the first cutting blade, to obtain a plurality of separated reflectors. Then, the plurality of separated reflectors may be peeled off from the dicing film and respectively packaged in periscope camera modules.

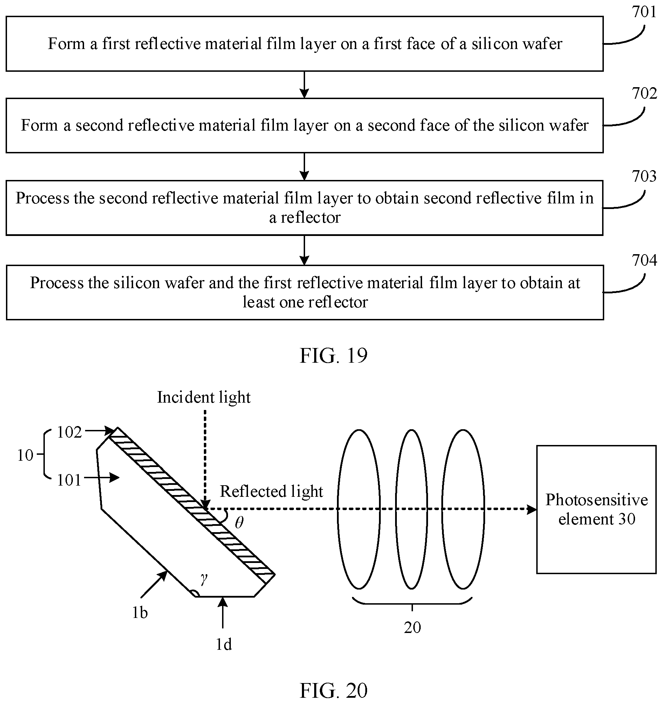

FIG. 19 is a flowchart of yet another method for manufacturing a reflector according to an embodiment of this application. The method may be used to manufacture a reflector including second reflective film. As shown in FIG. 19, the method may include the following steps.

Step 701: Form a first reflective material film layer on a first face of a silicon wafer.

For an implementation process of step 701, refer to the foregoing step 401. Details are not described herein again.

Step 702: Form a second reflective material film layer on a second face of the silicon wafer.

In this embodiment of this application, a material the same as that of the first reflective material film layer may be used to form the second reflective material film layer on the second face of the silicon wafer. For an implementation process of step 702, also refer to the foregoing step 401. Details are not described herein again.

Reflective material film layers made of a same material are formed on the first face and the second face of the silicon wafer, so that two types of stress generated by a thin-film coating process can be offset by each other, to further reduce deformation of the silicon wafer generated during thin-film coating, thereby ensuring flatness of the prepared reflector.

Step 703: Process the second reflective material film layer to obtain second reflective film in the reflector.

It may be seen with reference to FIG. 8 that the second reflective film 103 is located on a second surface 1b of a silicon-based substrate 101 in the finally formed reflector. In this embodiment of this application, the second reflective material film layer may be cut by using a cutting blade, to obtain the second reflective film in the reflector. For example, the second reflective material film layer and the second face of the silicon wafer may be cut by using a first cutting blade, to obtain the second reflective film in the reflector, and form a second side face of the silicon-based substrate in the reflector. For an implementation process of step 703, refer to the foregoing step 503 or the foregoing step 605. Details are not described herein again.

Step 704: Process the silicon wafer and the first reflective material film layer to obtain at least one reflector.

For an implementation process of step 704, refer to the foregoing step 504 or the foregoing step 603. Details are not described herein again.

Optionally, an order of the steps of the method for manufacturing a reflector provided in the embodiments of this application may be appropriately adjusted, and the steps may be correspondingly increased or decreased as required. For example, step 602 may be performed before step 601, and step 702 may be performed before step 701. Any method variation readily figured out by any person skilled in the art within the technical scope disclosed in this application shall fall within the protection scope of this application. Therefore, details are not described herein again.

In summary, embodiments of this application provide a method for manufacturing a reflector. In the method, a silicon wafer is used as a base to manufacture a reflector, to effectively reduce a volume and quality of the reflector. In addition, in the reflector manufactured by using the method, an included angle between a second side face and a second surface of the silicon-based substrate is an obtuse angle, to ensure that after the reflector is arranged in an inclined manner, a right angle protruding outward is not formed between the second side face and the second surface. Therefore, space occupied when the reflector applied to a periscope camera module can be reduced, and further, a risk of cracking or edge breakage of a side edge of the silicon-based substrate caused due to collision or friction during assembly of the reflector can be effectively reduced. Moreover, because a Young's modulus of the silicon wafer is relatively high, coating of a surface of the silicon wafer with a reflective material film layer does not cause relatively large deformation of the silicon wafer, which can ensure relatively high quality of the prepared reflector.

An embodiment of this application further provides a lens module. The lens module may be a periscope lens module. As shown in FIG. 20, the lens module includes: the reflector 10 provided in the foregoing embodiment, a lens set 20, and a photosensitive element 30.

The lens set 20 is located between the reflector 10 and the photosensitive element 30, first reflective film 102 in the reflector 10 is closer to the lens set 20 than a silicon-based substrate 101, and the first reflective film 102 is configured to reflect incident light to the lens set 20. For example, the first reflective film 102 may change an optical path direction of the incident light by 90°, so that the incident light is transmitted to the lens set 20. The lens set 20 may then converge light reflected by the first reflective film 102 and transmit the light to the photosensitive element 30.

The lens set 20 may include a plurality of lenses. The photosensitive element 30 may be a complementary metal oxide semiconductor (complementary metal oxide semiconductor, CMOS) device.

Optionally, as shown in FIG. 20, the reflector 10 in the lens module is arranged to be inclined, and an included angle between the first reflective film 102 and an optical axis of the lens set 20 is *θ*, where the included angle *θ* is an acute angle. In order to enable a second side face 1d of the silicon-based substrate 101 to be parallel to the optical axis of the lens set 20, an included angle δ between the second side face 1d and the first surface 1a of the silicon-based substrate 101 may be designed to be the same as the included angle *θ*. In other words, an included angle γ between the second side face 1d and the second surface 1b of the silicon-based substrate 101 may be designed as an angle supplementary to the included angle *θ*.

Optionally, the included angle between the optical axis of the lens set 20 in the lens module and the incident light may be a right angle. Accordingly, the included angle between the first reflective film 102 and the optical axis of the lens set 20 may be 45°, the included angle δ between the second side face 1d and the first surface 1a of the silicon-based substrate 101 is 45°, and the included angle γ between the second side face 1d and the second surface 1b of the silicon-based substrate 101 may be 135°. Therefore, it may be ensured that the light reflected by the first reflective film 102 can be transmitted to the lens set 20 in a direction parallel or approximately parallel to the optical axis of the lens set 20. The incident light is incident on a silicon-based planar reflector through a light window, is reflected by the reflector with an optical path change of 90°, and then is converged by the lens set and finally irradiated on the CMOS photosensitive element.

The included angle γ between the second side face 1d and the second surface 1b of the silicon-based substrate 101 is designed as an angle supplementary to the included angle *θ*, so that in the camera module, the second side face 1d of the silicon-based substrate 101 is parallel to the optical axis of the lens set 20, thereby ensuring that a right angle protruding outward is not formed between the second side face 1d and the second surface 1b. Therefore, space occupied by the reflector 10 in the camera module can be reduced, further, a risk of cracking or edge breakage of a side edge of the silicon-based substrate 101 caused due to collision or friction during assembly of the reflector 10 can be effectively reduced.

In summary, an embodiment of this application provides a lens module. A reflector in the lens module has a relatively small volume and relatively small mass, to ensure that a volume and mass of the lens module are also relatively small. In addition, the included angle between the second side face and the second surface of the silicon-based substrate in the reflector is an obtuse angle. Therefore, space occupied when the reflector applied to a periscope camera module can be reduced, and further, a risk of cracking or edge breakage of a side edge of the silicon-based substrate caused due to collision or friction during assembly of the reflector can be effectively reduced.

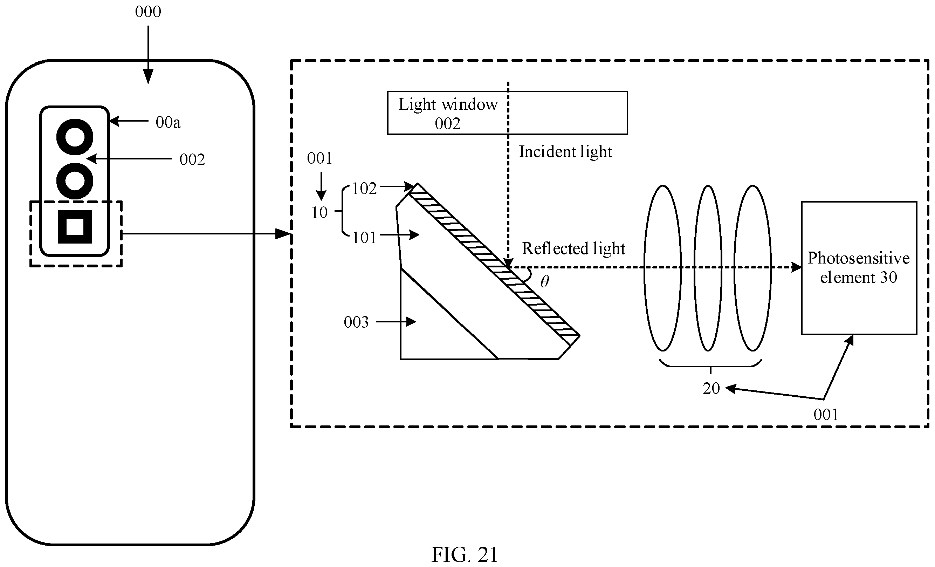

An embodiment of this application further provides an electronic device. As shown in FIG. 21, the electronic device may include: a housing 000, and the lens module 001 that is provided in the foregoing embodiment and that is arranged in the housing 000.

Optionally, as shown in FIG. 21, the electronic device further includes a light window 002. The housing 000 is provided with a slot 00a, and the light window 002 may be arranged in the slot 00a for light transmission. To be specific, the light window 002 may transmit incident light to first reflective film 102 of a reflector 10. An included angle between the light window 002 and the first reflective film 102 may be 45°. The light window 002 may be made of a transparent material, such as transparent optical glass.

Still refer to FIG. 21. The electronic device further includes a reflector fixing structure 003, and the reflector fixing structure 003 is located on a bottom surface of the reflector 10, namely, a surface, opposite to the first reflective film 102, of the reflector 10. The reflector fixing structure 003 is configured to support the reflector 10 so that the reflector 10 is fixed in the housing 000. The reflector fixing structure 003 may be fixedly connected to the reflector 10 in a manner such as bonding with glue.

Optionally, as shown in FIG. 21, the electronic device provided in this embodiment of this application may be a mobile phone. Alternatively, the electronic device may be a device having a camera function, such as a tablet computer or a wearable device.

In summary, an embodiment of this application provides an electronic device. A reflector used by a lens module in the electronic device has a relatively small volume and relatively small mass. Therefore, a volume and mass of the lens module are relatively small, so that a volume and mass of the electronic device can be reduced. In addition, to achieve an image stabilization function, the electronic device may be further provided with a motor for driving the reflector to deflect or translate. Because the mass of the reflector used in the electronic device is relatively small, power consumption of the motor can be reduced, thereby reducing power consumption of the electronic device, and further, deflection frequency of the reflector can be improved, thereby improving image stabilization performance of the electronic device.

The words such as "first" and "second" in this application are used to distinguish between same or similar items that have substantially a same effect and function. It should be understood that the elements described by the words such as "first" and "second" have no logical or temporal dependency, and quantities and an execution order are not limited either. It should be further understood that, although terms such as "first" and "second" are used to describe the elements in the foregoing description, these elements should not be limited by the terms. These terms are merely intended to distinguish one element from another. For example, without departing from the scope of the described examples, a first side face may be referred to as a second side face, and similarly, a second side face may be referred to as a first side face. Both the first side face and the second side face may be side faces, and in some cases, may be separate and distinct side faces.

The term "at least one" in this application means one or more, and "a plurality of" in this application means two or more. For example, a plurality of reflectors indicate two or more reflectors.

The foregoing descriptions are merely optional embodiments of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. A reflector, wherein the reflector comprises: a silicon-based substrate and first reflective film;
the silicon-based substrate has a first surface and a second surface opposite to each other, a first side face, and a second side face, wherein the first side face is connected to both the first surface and the second side face, and the second side face is connected to the second surface; and
the first reflective film is located on the first surface, an included angle between the first side face and the first surface is greater than a first angle threshold, an included angle between the second side face and the first side face is greater than a second angle threshold, and an included angle between the second side face and the second surface is an obtuse angle.

2. The reflector according to claim 1, wherein an included angle between the second side face and the first surface is 45 degrees.

3. The reflector according to claim 1 or 2, wherein the reflector further comprises: second reflective film located on the second surface, and a material of the second reflective film is the same as that of the first reflective film.

4. The reflector according to any one of claims 1 to 3, wherein a material of the silicon-based substrate is monocrystalline silicon with a target crystallographic orientation.

5. The reflector according to claim 4, wherein the target crystallographic orientation is (111).

6. The reflector according to any one of claims 1 to 5, wherein the first reflective film may be dielectric film or metal film.

7. The reflector according to any one of claims 1 to 6, wherein a height of the first side face is equal to 0, and a height direction of the first side face is perpendicular to the first surface.

8. A method for manufacturing a reflector, wherein the method comprises:
forming a first reflective material film layer on a first face of a silicon wafer; and
processing the silicon wafer and the first reflective material film layer to obtain at least one reflector, wherein the reflector comprises a silicon-based substrate obtained by processing the silicon wafer, and first reflective film obtained by processing the first reflective material film layer, wherein
the silicon-based substrate has a first surface and a second surface opposite to each other, a first side face, and a second side face, the first side face is connected to both the first surface and the second side face, the second side face is connected to the second surface, the first reflective film is located on the first surface, an included angle between the first side face and the first surface is greater than a first angle threshold, an included angle between the second side face and the first side face is greater than a second angle threshold, and an included angle between the second side face and the second surface is an obtuse angle.

9. The method according to claim 8, wherein the processing the silicon wafer and the first reflective material film layer comprises:
cutting a second face of the silicon wafer by using a first cutting blade to form a second side face of the reflector, wherein a cutting depth of the first cutting blade is less than a thickness of the silicon wafer, and the second face and the first face are two opposite faces of the silicon wafer; and
continuing to cut the silicon wafer by using a second cutting blade, and cutting the first reflective material film layer, to form a first side face of the reflector and the first reflective film of the reflector.

10. The method according to claim 8, wherein the processing the silicon wafer and the first reflective material film layer comprises:
processing the first reflective material film layer and the silicon wafer, starting from a side, facing away from the silicon wafer, of the first reflective material film layer to form a first side face of the reflector and the first reflective film of the reflector; and
cutting the second face of the silicon wafer by using the first cutting blade to form a second side face of the reflector, wherein the second face and the first face are two opposite sides of the silicon wafer.

11. The method according to claim 10, wherein the processing the first reflective material film layer and the silicon wafer, starting from a side, facing away from the silicon wafer, of the first reflective material film layer comprises:
etching the first reflective material film layer and the silicon wafer, starting from the side, facing away from the silicon wafer, of the first reflective material film layer; or
cutting the first reflective material film layer and the silicon wafer, starting from the side, facing away from the silicon wafer, of the first reflective material film layer by using a second cutting blade.

12. The method according to claim 10 or 11, wherein before the processing the first reflective material film layer and the silicon wafer, starting from a side, facing away from the silicon wafer, of the first reflective material film layer, the method further comprises:
forming an alignment mark on the second surface of the silicon wafer;
the processing the first reflective material film layer and the silicon wafer, starting from a side, facing away from the silicon wafer, of the first reflective material film layer comprises:
processing, by using the alignment mark as a reference, the first reflective material film layer and the silicon wafer, starting from the side, facing away from the silicon wafer, of the first reflective material film layer; and
the cutting a second face of the silicon wafer by using a first cutting blade comprises:
cutting the second face of the silicon wafer by using the alignment mark as a reference and the first cutting blade.

13. The method according to any one of claims 8 to 12, wherein the method further comprises:
using a material the same as that of the first reflective material film layer to form a second reflective material film layer on the second face of the silicon wafer; and
processing the second reflective material film layer to obtain second reflective film in the reflector, wherein the second reflective film is located on the second surface of the silicon-based substrate.

14. A lens module, wherein the lens module comprises the reflector according to any one of claims 1 to 7, a lens set, and a photosensitive element; and
the lens set is located between the reflector and the photosensitive element, first reflective film in the reflector is closer to the lens set than a silicon-based substrate, and the first reflective film is configured to reflect incident light to the lens set.

15. The lens module according to claim 14, wherein an included angle between a second side face and a first surface of the silicon-based substrate is equal to an included angle between the first reflective film and an optical axis of the lens set.

16. the lens module according to claim 14 or 15, wherein the included angle between the first reflective film and the optical axis of the lens set is 45 degrees.

17. An electronic device, wherein the electronic device comprises a housing, and the lens module arranged in the housing according to any one of claims 14 to 16.
